# EUROPEAN PATENT SPECIFICATION

(11) **EP 1 812 825 B1**
(45) Date of publication and mention of the grant of the patent: **22.04.2009**
(21) Application number: 05819484.6
(22) Date of filing: 20.10.2005
(51) Int. Cl.: G03F 7/30

(54) **DYNAMIC DEVELOPMENT PROCESS WITH DE-IONIZED WATER PUDDLE**
DYNAMISCHER ENTWICKLUNGSPROZESS MIT EINER ENTIONISIERTEN WASSERLACHE
PROCESSUS DE DEVELOPPEMENT DYNAMIQUE AU MOYEN D'UN BAIN D'EAU DESIONISEE

(30) Priority: 20.10.2004 US 620915 P
(43) Date of publication of application: 01.08.2007
(73) Proprietor: NXP B.V., 5656 AG Eindhoven (NL)
(72) Inventor: ROEHRLE, Eugen, NL-5621 BA Eindhoven (NL); MAJONI, Stefan, NL-5621 BA Eindhoven (NL)
(74) Representative: van der Veer, Johannis Leendert
(86) International application number: PCT/IB2005/053449
(87) International publication number: WO 2006/043253

(56) References cited:
- US-A- 5 885 755
- US-A- 6 159 662
- US-A1- 2001 018 167
- US-A1- 2004 072 450
- US-B1- 6 265 323

## Description

The invention relates to semiconductor processing. More particularly this invention relates to increasing the consistency of photo resist development in a photo-lithographic process.

The electronics industry continues to rely upon advances in semiconductor technology to realize higher-function devices in more compact areas. For many applications realizing higher-functioning devices requires integrating a large number of electronic devices into a single silicon wafer. As the number of electronic devices per given area of the silicon wafer increases, the manufacturing process becomes more difficult.

Many varieties of semiconductor devices have been manufactured with various applications in numerous disciplines. Such silicon-based semiconductor devices often include metal-oxide-semiconductor field-effect transistors (MOSFET), such as p-channel MOS (PMOS), n-channel MOS (NMOS) and complementary MOS (CMOS) transistors, bipolar transistors, BiCMOS transistors. Such MOSFET devices include an insulating material between a conductive gate and silicon-like substrate; therefore, these devices are generally referred to as IGFETs (insulated-gate FET).

Each of these semiconductor devices generally includes a semiconductor substrate on which a number of active devices are formed. The particular structure of a given active device can vary between device types. For example, in MOS transistors, an active device generally includes source and drain regions and a gate electrode that modulates current between the source and drain regions.

Furthermore, such devices may be digital or analog devices produced in a number of wafer fabrication processes, for example, CMOS, BiCMOS, Bipolar, etc. The substrates may be silicon, gallium arsenide (GaAs) or other substrate suitable for building microelectronic circuits thereon.

One important aspect in manufacturing is the formation of devices, or portions thereof, using photolithography and etching processes. In photolithography, a wafer substrate is coated with a light-sensitive material called photo-resist. Next, the wafer is exposed to light; the light striking the wafer is passed through a mask plate. This mask plate defines the desired features to be printed on the substrate. After exposure, the resist-coated wafer substrate is developed. The desired features as defined on the mask are retained on the photo resist-coated substrate. Exposed areas of resist are washed away with a developer. The wafer having the desired features defined is subjected to etching or ion implantation. Depending upon the production process, the etching may either be a wet etch, in which liquid chemicals are used to remove wafer material or a dry etch, in which wafer material is subjected to a radio frequency (RF) induced plasma. Depending upon the features defined in the photo resist, ion implantation defines the local doping level.

More details regarding apparatus used to develop exposed photo resist may be found in U.S. Patent 5,885, 755 of Nakagawa et al. titled, "Developing Treatment Apparatus Used in the Process for Manufacturing a Semiconductor Device, and Method for the Developing Treatment," relates to a developing treatment apparatus used in the process for manufacturing a semiconductor device, and a method for the developing treatment, in particular to an apparatus and a method applied to treatment for developing a photo resist which is formed on a semiconductor wafer and has a circuit pattern exposed to light, in a photolithography process, and is incorporated by reference in its entirety.

Document US 2004/072450 Al describes a spin coating method and apparatus for spin coating process solutions onto semiconductor wafers. It is disclosed a pre-wetting of the photo-resist before the developer is brought onto the photo-resist. The pre-wetting action starts before the developer is brought onto the surface of the substrate. It is also disclosed that there is a movement of the nozzle for deposition. The sequence of the method is as follows: First the substrate rotates and speeds up to 2500 RPM. Then pre-wetting occurs after about 2.5 seconds from the start of the rotation. After that a deposition of developer starts before the end of the pre-wetting. The two depositions overlap essentially. During the last period of deposition of developer the substrate stops rotating.

Also US 6 159 662 A discloses a method for developing a photo-resist pattern on a semiconductor wafer using the puddle method, wherein the wafer is subject to several periods of slow rotation. Between two slow rotation periods the wafer is idle meaning that there is no rotation at all. A movement of a deposition nozzle is not mentioned.

As device geometry approaches the sub-micron realm, preparation of the wafer for photolithography becomes increasingly important. Integral to successful wafer fabrication is the consistent and reliable application of photo resist. Improper application of photo resist on the wafer substrate may result in having to rework the wafer at the given process step. Rework results in higher production costs and oftentimes, lower product yield.

Photo resist if often applied to a substrate that is mounted on chuck in a machine that spins-on the resist. The wafer is loaded on the chuck and held down with vacuum. Through a nozzle, a measured amount of resist is deposited on the wafer. The chuck is rotated at high speed and the centrifugal force on the surface of the wafer spreads the resist across the wafer. A number of parameters determine the characteristics of the applied photo resist.

Of particular importance is the development process a substrate undergoes after the application and exposure of the resist. Obviously the developer and the development process play a crucial role in the semiconductor manufacturing with the following requirements: 1) Resolution of the lithography process, contrast; 2) Process window regarding focus (depth of focus); 3) Process window regarding light intensity (exposure latitude); 4) Low variation of line width across wafer; and 5) Low variation of line width of neighboring lines; 6) low defect rate.

The consistent maintenance of critical dimensions (CDs) of features is important in analog and RF circuits in which components have to be matched in terms of gain, resistance, and other parameters.

There exists a need to provide for a photo resist development process that ensures consistent line width among neighboring lines printed on a substrate. In an example embodiment, in a process apparatus, there is method for developing an exposed photo resist surface on a substrate. The method comprises placing the substrate on a platen and rotating the platen. From a dispense nozzle during platen rotation, a wetting agent is dispensed on the exposed photo resist surface. Developer is dispensed from the dispense nozzle on the exposed photo resist surface. The developer mixes with the wetting agent present on the photo resist surface and the wafer is rotated at a first low speed. The dispense nozzle moves from wafer center to wafer edge repeatedly, forming a puddle of developer/wetting agent covering the exposed photo resist surface. By a second low speed rotation, the puddle of developer/wetting agent covering the exposed photo resist surface on the substrate is agitated. An.additional feature of this embodiment further comprises rinsing off with pure water, the developer/wetting agent covering the exposed photo resist surface, as the substrate is rotated at a high speed and spin drying the wafer substrate. Furthermore, the wetting agent may be an aqueous solution containing at least one selected from the group including pure water, organic ammonium hydroxide, metal hydroxides, alcohols, amines, and surfactants. Also the developer may be an aqueous solution containing at least one selected from the group including tetra-methyl ammonium hydroxide, and metal hydroxides.

In another example embodiment, there is method for developing an exposed photo resist surface on a semiconductor wafer. The method comprises depositing DI water the exposed photo resist surface as the semiconductor wafer is rotated. Developer is deposited on the exposed photo resist surface. The developer mixes with the DI water present on the photo resist surface and the wafer is rotated at a first low speed, the dispense nozzle moves from wafer center to wafer edge repeatedly forming a puddle of developer/ DI water covering the exposed photo resist surface. The puddle of developer/DI water covering the exposed photo resist surface on the substrate is agitated by a second low speed rotation. With DI water, the developer/DI water covering the exposed photo resist surface is rinsed off as the semiconductor wafer is rotated at a high speed. The semiconductor wafer is spindried.

In yet another example embodiment, there is a method for manufacturing a semiconductor device; the method comprises, applying a photo resist surface onto a semiconductor wafer. By exposing the photo resist surface to light, a circuit pattern is rendered. The semiconductor wafer is placed into a process apparatus. While depositing DI water onto the photo resist surface, the semiconductor wafer is rotated. From a dispense nozzle in the process apparatus, developer is deposited on the photo resist surface; the developer mixes with the DI water present on the photo resist surface, as the semiconductor wafer being rotated at a first low speed, the dispense nozzle is moved from wafer center to wafer edge repeatedly, forming a puddle of developer/DI water covering the photo resist surface. The puddle of developer/DI water covering the photo resist surface on the semiconductor wafer is agitated by a second low speed rotation, thereby developing the photo resist. The embodiment may further comprise, after developing the photo resist, the rinsing off with DI water the puddle of developer/DI water covering the photo resist surface, as the semiconductor wafer is rotated at a high speed and spin drying the wafer substrate.

In yet another example embodiment, there is a system for manufacturing a semiconductor device. The system comprises means for applying a photo resist surface onto a semiconductor wafer, means for exposing the photo resist surface to light so as to render a circuit pattern, means for rotating the semiconductor wafer while depositing DI water on the photo resist surface, means for depositing developer on the photo resist surface, the developer mixing with the DI water present on the photo resist surface, the wafer being rotated at a first low speed, the dispense nozzle moving from wafer center to wafer edge repeatedly, forming a puddle of developer/DI water covering the photo resist surface, and means for agitating the puddle of developer/DI water covering the exposed photo resist surface on the semiconductor wafer by a second low speed rotation, thereby developing the photo resist.

The above summaries of the present invention are not intended to represent each disclosed embodiment, or every aspect, of the present invention. Other aspects and example embodiments are provided in the figures and the detailed description that follows.

The invention may be more completely understood in consideration of the following detailed description of various embodiments of the invention in connection with the accompanying drawings, in which:
FIG. 1 illustrates the significance of a non-linear resist response to exposure dose;
FIG. 2 depicts the impact of flowing resist developer on two neighboring lines in a conventional process;
FIG. 3 is a flowchart of an example process according to the present invention; and
FIG. 4 is a plot of an example develop recipe according to the present invention.

The present invention has been found to be useful in minimizing line width variation of neighboring lines. The process assures that features printed from the photo mask on a photo resist coated substrate receive consistent development across the entire substrate. Consistent development is achieved by overcoming topographical effects on the wafer surface that would tend to cause a difference in mechanical impact of the developer for one feature compared to another, resulting in local differences of the development rate. The user, as he applies developer on the exposed substrate, agitates the developer as it is dispensed onto the substrate. The agitation evens out the distribution of the developer so that the exposed resist is evenly developed over a pre-determined time.

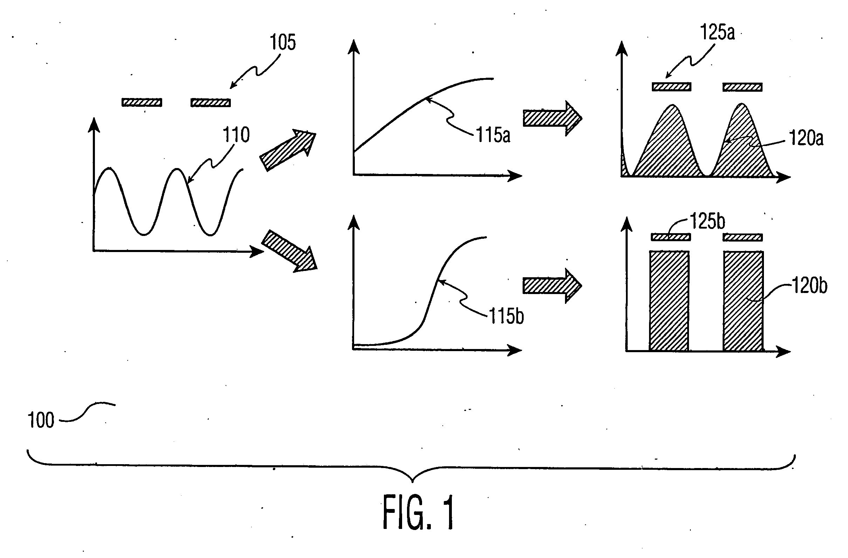

In modifying a resist process, it is desirable to amplify light intensity differences by the development process. Refer to FIG. 1. In an example process 100, a mask pattern 105 exposes a substrate (not illustrated) with radiation energy having an intensity distribution 110 shown as peaks and valleys. Depending upon the resist response function 115a, 115b, the response may be linear 115a or non-linear (e.g., a "step function") 115b. A resist that displays a linear rate versus dose behavior will reproduce (from mask 125a) the sinusoidal behavior of the aerial image 120a, while a non-linear resist response can reproduce (from the mask 125b) the desired binary image from the mask 125b in the final resist profiles 120b.

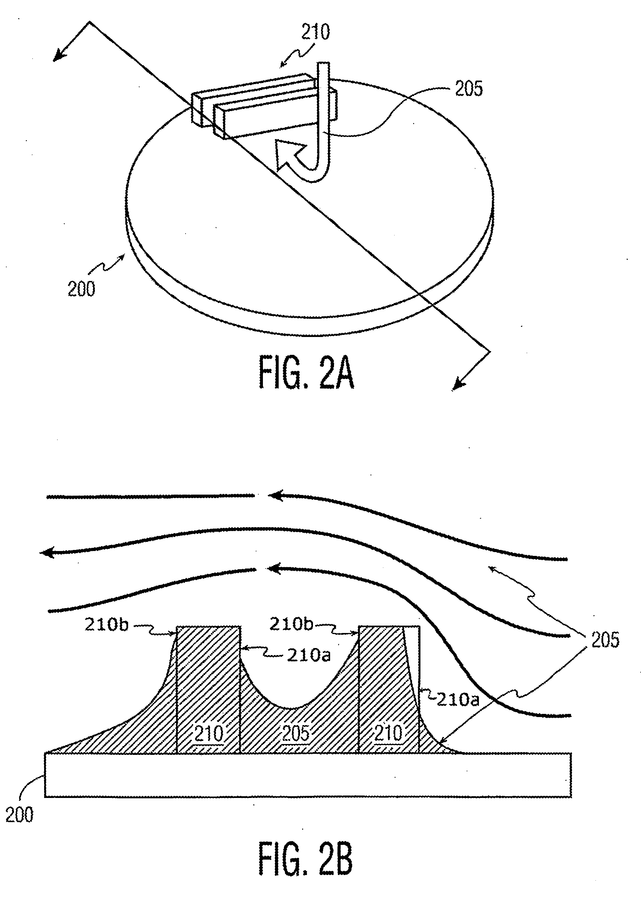

In using a more non-linear resist to achieve a sharp profile that closely corresponds with the mask pattern, the effects of uneven development have to be minimized. Refer to FIG. 2A. In example process, a photo resist-coated wafer substrate 200 has two neighboring lines 210 that have been printed onto resist surface. Developer 205 from nozzle is applied to the wafer substrate 200. Refer to FIG. 2B. The developer flows from nozzle 205 towards the wafer edge. The developer 205 has a stronger impact on an inner exposed line 210a than an outer, shadowed line 210b. Consequently, there is a systematic line width difference between neighboring lines. Such systematic deviation in line width is especially deleterious to analog circuits with respect to transistor, resistor, and capacitance mismatch.

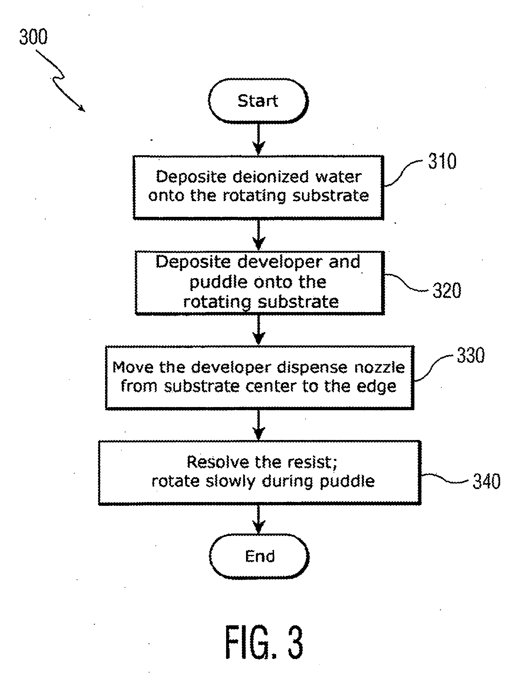

Refer to FIG. 3. In an example embodiment according to the present invention, a process 300 may be used to develop an exposed photo resist coated substrate. Within a process apparatus, to reduce the mechanical impact of the developer during apply, de-ionized water is deposited onto the rotating substrate 310. Developer is deposited and puddled onto the rotating substrate 320. To assure complete and homogeneous coverage at the slow wafer rotation, the developer dispense nozzle is moved from substrate center to the edge 330. By resolving the resist, the developer is modified. Therefore, local differences of resist features may result in local differences of development rate. These differences are minimized by agitation achieved by slow rotation during puddle 340.

Furthermore, the DI water (de-ionized) may be substituted by other aqueous solutions. These aqueous solutions may include but are not limited to organic ammonium hydroxide, metal hydroxides, alcohols, amines, and surfactants. In a particular process tetra-methyl-ammonia hydroxide (TMAH) has been found suitable.

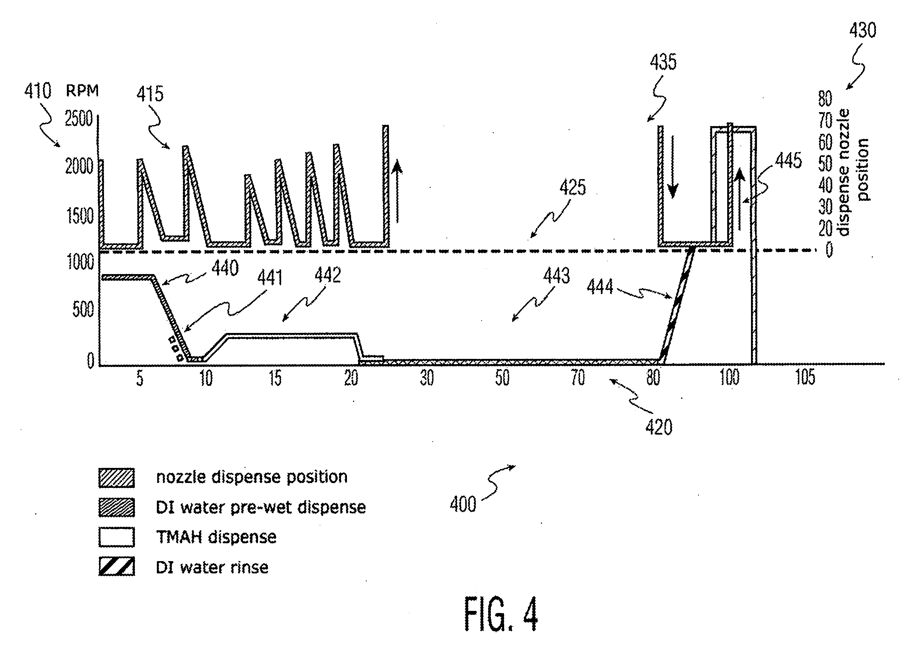

Refer to FIG. 4. In another example embodiment according to the present invention, an exposed photo resist-coated substrate may be developed. A process 400 is depicted in a multi-axis plot. Spin speed 410 in revolutions per minute (RPM) and dispense nozzle arm position 430 are plotted against time 420 in seconds (S). In the example process, a wafer having been printed with desired circuit features is placed within a develop apparatus. This apparatus has a vacuum platen that holds the wafer in place as it is spun. The wafer initially receives a DI water pre-wet dispense 440 and is spun at about 800 rpm for about 5 to 10 seconds. The spin speed is reduced to about 250 rpm and TMAH is dispensed 441 (at about 8 seconds) on the exposed photo resist surface on the wafer. The DI water puddles with the TMAH for about 2 seconds, after which TMAH is dispensed 442 for about another 10 to 12 seconds, at a speed of about 250 rpm. During this TMAH dispense 442 the dispense nozzle position 415oscillates from the center of the wafer to the outer edge of the wafer. After the TMAH dispense 442, the wafer is spun at about 10 rpm for about 60 seconds. The dynamic puddle 443 provides for even development of features, especially neighboring lines 210 as was depicted in FIGS. 2A and 2B. Having completed the dynamic puddle 443, the wafer is subjected to a DI water rinse for about 20 seconds with the speed ramped up from about 10 rpm to about 1200 rpm. The DI water for the rinse may be supplied from the same nozzle as that used for the developer or be from a separate source. After rinsing, the wafer is goes through a spin-dry cycle at a speed of about 1200 to about 2500 rpm. The developed features having been rendered onto the photo resist, the wafer is ready to undergo subsequent processing.

## Claims

1. A method (300) for developing an exposed photo resist surface on a substrate to be executed in a process apparatus, the method comprising:
- placing (310) the substrate on a platen and rotating the platen;
- depositing (320) a wetting agent from a dispense nozzle on the exposed photo resist surface during platen rotation;
- depositing developer from the dispense nozzle on the exposed photo resist surface, the developer mixing with the wetting agent present on the photo resist surface, the wafer being rotated at a first low speed, the dispense nozzle moving (330) from wafer center to wafer edge repeatedly, forming a puddle of developer/wetting agent covering the exposed photo resist surface; and
- agitating (340) the puddle of developer/wetting agent covering the exposed photo resist surface on the substrate by a second low speed rotation, the developer/wetting mixture developing the exposed photo resist.

2. The method as recited in claim 1, further comprising, rinsing off with pure water, the developer/wetting agent covering the exposed photo resist surface, as the substrate is rotated at a high speed; and spin drying the wafer substrate.

3. The method as recited in claim 1, wherein the wetting agent is pure water.

4. The method as recited in claim 1, wherein the wetting agent is an aqueous solution containing at least one selected from the group including organic ammonium hydroxide, metal hydroxides, alcohols, amines, and surfactants.

5. The method as recited in claim 1, wherein the developer is an aqueous solution containing at least one selected from the group including terra-methyl ammonium hydroxide, and metal hydroxides.

6. A method for developing an exposed photo resist surface on a semiconductor wafer, the method comprising:
- depositing DI water the exposed photo resist surface as the semiconductor wafer is rotated;
- depositing developer on the exposed photo resist surface, the developer mixing with the DI water present on the photo resist surface, the wafer being rotated at a first low speed, the dispense nozzle moving from wafer center to wafer edge repeatedly, forming a puddle of developer/ DI water covering the exposed photo resist surface;
- agitating the puddle of developer/DI water covering the exposed photo resist surface on the substrate by a second low speed rotation, the developer/wetting mixture developing the exposed photo resist;
- rinsing off with DI water, the developer/DI water covering the exposed photo resist surface, as the semiconductor wafer is rotated at a high speed; and
- spin drying the semiconductor wafer.

7. The method developing exposed photo resist on a semiconductor wafer as recited in claim 6, wherein the developer is an aqueous solution containing at least one selected from the group including tetra-methyl ammonium hydroxide, and metal hydroxides.

8. A method for manufacturing a semiconductor device comprising: applying a photo resist surface onto a semiconductor wafer;
- exposing the photo resist surface to light so as to render a circuit pattern; placing the semiconductor wafer into a process apparatus;
- rotating the semiconductor wafer while depositing DI water onto the photo resist surface;
- depositing developer from a dispense nozzle in the process apparatus, on the photo resist surface, the developer mixing with the DI water present on the photo resist surface, the semiconductor wafer being rotated at a first low speed, the dispense nozzle moving from wafer center to wafer edge repeatedly, forming a puddle of developer/DI water, covering the photo resist surface; and
- agitating the puddle of developer/DI water covering the photo resist surface on the semiconductor wafer by a second low speed rotation, thereby developing the photo resist.

9. The method for manufacturing a semiconductor device as recited in claim 8, further comprising, after developing the photo resist, rinsing off with DI water the puddle of developer/DI water covering the photo resist surface, as the semiconductor wafer is rotated at a high speed; and spin drying the wafer substrate.

10. A semiconductor device manufactured by the method as recited in claim 9.

11. System for manufacturing a semiconductor device, the system comprising:
- means for applying a photo resist surface onto a semiconductor wafer;
- means for exposing the photo resist surface to light so as to render a circuit pattern;
- means for rotating the semiconductor wafer while depositing DI water on the photo resist surface;
- means for depositing developer on the photo resist surface, the developer mixing with the DI water present on the photo resist surface, the wafer being rotated at a first low speed, the dispense nozzle moving from wafer center to wafer edge repeatedly, forming a puddle of developer/DI water covering the photo resist surface; and means for agitating the puddle of developer/DI water covering the exposed photo resist surface on the semiconductor wafer by a second low speed rotation, thereby developing the photo resist.

## Patentansprüche

1. Verfahren (300) zum Entwickeln einer belichteten Fotoresistoberfläche auf einem Substrat, auszuführen in einer Prozessapparatur, wobei das Verfahren umfasst:
- Platzieren (310) des Substrats auf einer Auflageplatte und Drehen der Auflageplatte,
- Aufbringen (320) eines Netzmittels aus einer Auftragsdüse auf die belichtete Fotoresistoberfläche während des Drehens der Auftragsplatte,
- Aufbringen von Entwickler aus der Auftragsdüse auf die belichtete Fotoresistoberfläche, wobei sich der Entwickler mit dem auf der Fotoresistoberfläche vorhandenen Netzmittel vermischt, der Wafer bei einer ersten niedrigen Geschwindigkeit gedreht wird, die Auftragsdüse sich wiederholt von Wafermitte zu Waferkante bewegt (330), wobei eine Lache aus Entwickler/Netzmittel gebildet wird, welche die belichtete Fotoresistoberfläche bedeckt, und
- Bewegen (340) der Lache aus Entwickler/Netzmittel, welche die belichtete Fotoresistoberfläche auf dem Substrat bedeckt, durch eine zweite Drehung mit niedriger Geschwindigkeit, wobei die Mischung aus Entwickler/Netzmittel den belichteten Fotoresist entwickelt.

2. Das Verfahren nach Anspruch 1, weiterhin umfassend Abspülen des die belichtete Fotoresistoberfläche bedeckenden Entwicklers/Netzmittels mit Reinwasser, während das Substrat bei einer hohen Geschwindigkeit gedreht wird, und Trockenschleudern des Wafersubstrats.

3. Das Verfahren nach Anspruch 1, wobei das Netzmittel Reinwasser ist.

4. Das Verfahren nach Anspruch 1, wobei das Netzmittel eine wässrige Lösung ist, die zumindest eines ausgewählt aus der Gruppe einschließend Ammoniumhydroxid, Metallhydroxide, Alkohole, Amine und grenzflächenaktive Stoffe enthält.

5. Das Verfahren nach Anspruch 1, wobei der Entwickler eine wässrige Lösung ist, die zumindest eines ausgewählt aus der Gruppe einschließend Tetramethylammoniumhydroxid und Methallhydroxide enthält.

6. Verfahren zum Entwickeln einer belichteten Fotoresistoberftäche auf einem Halbleiterwafer, wobei das Verfahren umfasst:
- Aufbringen von entionisiertem Wasser auf die belichtete Fotoresistoberfläche, während der Halbleiterwafer gedreht wird,
- Aufbringen von Entwickler auf die belichtete Fotoresistoberfläche, wobei sich der Entwickler mit dem auf der Fotoresistoberfläche vorhandenen entionisierten Wasser vermischt, der Wafer bei einer ersten niedrigen Geschwindigkeit gedreht wird, die Auftragsdüse sich wiederholt von Wafermitte zu Waferkante bewegt, wobei eine Lache aus Entwickler/entionisiertem Wasser gebildet wird, welche die belichtete Fotoresistoberfläche bedeckt,
- Bewegen der Lache aus Entwickler/entionisiertem Wasser, welche die belichtete Fotoresistoberfläche auf dem Substrat bedeckt, durch eine zweite Drehung mit niedriger Geschwindigkeit, wobei die Mischung aus Entwickler/entionisiertem Wasser den belichteten Fotoresist entwickelt,
- Abspülen des die belichtete Fotoresistoberfläche bedeckenden Entwicklers/entionisierten Wassers mit entionisiertem Wasser, während das der Halbleiterwafer bei einer hohen Geschwindigkeit gedreht wird, und
- Trockenschleudern des Halbleiterwafers.

7. Das Verfahren zum Entwickeln von belichtetem Fotoresist auf einem Halbleiterwafer nach Anspruch 6, wobei der Entwickler eine wässrige Lösung ist, die zumindest eines ausgewählt aus der Gruppe einschließend Tetramethylammoniumhydroxid und Methallhydroxide enthält.

8. Verfahren zum Herstellen eines Halbleiterbauelements, umfassend: Auftragen einer Fotoresistoberfläche auf einen Halbleiterwafer,
- Belichten der Fotoresistoberfläche mit Licht, um ein Schaltungsmuster zu erhalten, Platzieren des Halbleiterwafers in eine Prozessapparatur,
- Drehen des Halbleiterwafers während des Aufbringens von entionisiertem Wasser auf die Fotoresistoberfläche,
- Aufbringen von Entwickler aus einer Auftragsdüse in der Prozessapparatur auf die Fotoresistoberfläche, wobei sich der Entwickler mit dem auf der Fotoresistoberfläche vorhandenen entionisierten Wasser vermischt, der Halbleiterwafer bei einer ersten niedrigen Geschwindigkeit gedreht wird, die Auftragsdüse sich wiederholt von Wafermitte zu Waferkante bewegt, wobei eine Lache aus Entwickler/entionisiertem Wasser gebildet wird, welche die Fotoresistoberfläche bedeckt, und
- Bewegen der Lache aus Entwickler/entionisiertem Wasser, welche die Fotoresistoberfläche auf dem Halbleiterwafer bedeckt, durch eine zweite Drehung mit niedriger Geschwindigkeit, wodurch der Fotoresist entwickelt wird.

9. Das Verfahren zum Herstellen eines Halbleiterbauelements nach Anspruch 8, weiterhin umfassend Abspülen der die Fotoresistoberfläche bedeckenden Lache aus Entwickler/entionisiertem Wasser mit entionisiertem Wasser nach Entwickeln des Fotoresists, während der Halbleiterwafer bei einer hohen Geschwindigkeit gedreht wird, und Trockenschleudern des Wafersubstrats.

10. Halbleiterbauteil, hergestellt nach dem Verfahren nach Anspruch 9.

11. System zum Herstellen eines Halbleiterbauteils, wobei das System umfasst:
- Mittel zum Auftragen einer Fotoresistoberfläche auf einen Halbleiterwafer,
- Mittel zum Belichten der Fotoresistoberfläche mit Licht, um ein Schaltungsmuster zu erhalten;
- Mittel zum Drehen des Halbleiterwafers während des Aufbringens von entionisiertem Wasser auf die Fotoresistoberfläche,
- Mittel zum Aufbringen von Entwickler auf die Fotoresistoberfläche, wobei sich der Entwickler mit dem auf der Fotoresistoberfläche vorhandenen entionisierten Wasser vermischt, der Wafer bei einer ersten niedrigen Geschwindigkeit gedreht wird, die Auftragsdüse sich wiederholt von Wafermitte zu Waferkante bewegt, wobei eine Lache aus Entwickler/entionisiertem Wasser gebildet wird, welche die belichtete Fotoresistoberfläche bedeckt, und Mittel zum Bewegen der Lache aus Entwickler/entionisiertem Wasser, welche die belichtete Fotoresistoberfläche auf dem Halbleiterwafer bedeckt, durch eine zweite Drehung mit niedriger Geschwindigkeit, wodurch der Fotoresist entwickelt wird.

## Revendications

1. Procédé (300) pour développer une surface de résine photosensible exposée sur un substrat à réaliser dans un appareil de process, le procédé consistant :
- à placer (310) le substrat sur un plateau et à faire tourner le plateau ;
- à déposer (320) au cours de la rotation du plateau un agent mouillant provenant d'une buse d'apport sur la surface de résine photosensible exposée ;
- à déposer du développeur à partir de la buse d'apport sur la surface de résine photosensible exposée, le développeur se mélangeant avec l'agent mouillant présent sur la surface de résine photosensible, la tranche étant mise en rotation à une première vitesse lente, la buse d'apport se déplaçant (330) du centre de la tranche au bord de la tranche de manière répétitive, formant une flaque de développeur / d'agent mouillant recouvrant la surface de la résine photosensible exposée; et
- à agiter (340) la flaque de développeur / d'agent mouillant recouvrant la surface de la résine photosensible exposée sur le substrat à une deuxième vitesse de rotation lente, le mélange développeur / agent mouillant développant la résine photosensible exposée.

2. Procédé selon la revendication 1, comportant en outre le rinçage, à l'eau pure, du développeur / de l'agent mouillant recouvrant la surface de la résine photosensible exposée, pendant que le substrat est mis en rotation rapide ; et un séchage par rotation de la tranche de substrat.

3. Procédé selon la revendication 1, dans lequel l'agent mouillant est de l'eau pure.

4. Procédé selon la revendication 1, dans lequel l'agent mouillant est une solution aqueuse contenant au moins un élément sélectionné appartenant au groupe contenant un hydroxyde d'ammonium organique, des hydroxydes métalliques, des alcools, des amines et des agents tensio-actifs.

5. Procédé selon la revendication 1, dans lequel le développeur est une solution aqueuse contenant au moins un élément sélectionné appartenant au groupe contenant de l'hydroxyde de tétra-méthyle ammonium et des hydroxydes métalliques.

6. Procédé pour développer une surface de résine photosensible exposée sur une tranche de semi-conducteur, le procédé consistant :
- à déposer de l'eau désionisée sur la surface de la résine photosensible exposée pendant que la tranche de semi-conducteur est mise en rotation ;
- à déposer du développeur sur la surface de la résine photosensible exposée, le développeur se mélangeant à l'eau désionisée présente sur la surface de la résine photosensible, la tranche étant mise en rotation à une première vitesse lente, la buse d'apport se déplaçant du centre de la tranche au bord de la tranche de manière répétitive, formant une flaque de développeur / d'eau désionisée recouvrant la surface de la résine photosensible exposée;
à agiter la flaque de développeur / d'eau désionisée recouvrant la surface de la résine photosensible exposée sur le substrat à une deuxième vitesse de rotation lente, le mélange développeur / agent mouillant développant la résine photosensible exposée.
- à rincer à l'eau désionisée le développeur / l'eau désionisée recouvrant la surface de la résine photosensible exposée, pendant que la tranche de semi-conducteur est mise en rotation rapide ; et
- à sécher par rotation la tranche de semi-conducteur.

7. Procédé de développement de la résine photosensible exposée sur une tranche de semi-conducteur selon la revendication 6, dans lequel le développeur est une solution aqueuse contenant au moins un élément sélectionné appartenant au groupe contenant de l'hydroxyde de tétra-méthyle ammonium et des hydroxydes métalliques.

8. Procédé de fabrication d'un dispositif à semi-conducteur comprenant : l'application d'une surface de résine photosensible sur une tranche de semi-conducteur ;
- l'exposition de la surface de résine photosensible à la lumière pour effectuer le rendu d'un motif de circuit ; la mise en place de la tranche de semi-conducteur dans un appareil de process ;
- la mise en rotation de la tranche de semi-conducteur pendant que l'on dépose de l'eau désionisée sur la surface de la résine photosensible ;
- le dépôt de développeur sur la surface de la résine photosensible exposée, à partir d'une buse d'apport dans l'appareil de process, le développeur se mélangeant à l'eau désionisée présente sur la surface de la résine photosensible, la tranche de semi-conducteur étant mise en rotation à une première vitesse lente, la buse d'apport se déplaçant du centre de la tranche au bord de la tranche de manière répétitive, formant une flaque de développeur / d'eau désionisée recouvrant la surface de la résine photosensible exposée ; et
- l'agitation de la flaque de développeur / d'eau désionisée recouvrant la surface de la résine photosensible exposée sur la tranche de semi-conducteur à une deuxième vitesse de rotation lente, développant ainsi la résine photosensible.

9. Procédé de fabrication d'un dispositif à semi-conducteur selon la revendication 8, comprenant en outre, après développement de la résine photosensible, un rinçage à l'eau désionisée de la flaque de développeur / d'eau désionisée recouvrant la surface de la résine photosensible, pendant que la tranche de semi-conducteur est mise en rotation rapide ; et un séchage par rotation de la tranche de substrat.

10. Dispositif à semi-conducteur fabriqué selon le procédé de la revendication 9.

11. Système de fabrication d'un dispositif à semi-conducteur, le système comprenant:
- des moyens pour appliquer une surface de résine photosensible sur une tranche de semi-conducteur ;
- des moyens pour exposer la surface de résine photosensible à la lumière pour effectuer le rendu d'un motif de circuit ;
- des moyens pour mettre en rotation la tranche de semi-conducteur pendant que l'on dépose de l'eau désionisée sur la surface de la résine photosensible ;
- des moyens pour déposer du développeur sur la surface de la résine photosensible, le développeur se mélangeant à l'eau désionisée présente sur la surface de résine photosensible, la tranche étant mise en rotation à une première vitesse lente, la buse d'apport se déplaçant du centre de la tranche au bord de la tranche de manière répétitive, formant une flaque de développeur / d'eau désionisée recouvrant la surface de la résine photosensible exposée ; et des moyens pour agiter la flaque de développeur / d'eau désionisée recouvrant la surface de la résine photosensible exposée sur la tranche de semi-conducteur à une deuxième vitesse de rotation lente, développant ainsi la résine photosensible.
